# FASCICULE DE BREVET EUROPEEN

(11) **EP 4 531 519 B1**
(45) Date de publication et mention de la délivrance du brevet: **01.04.2026**
(21) Numéro de dépôt: 24202486.7
(22) Date de dépôt: 25.09.2024
(51) Int. Cl.: H10H 20/01, H10H 29/14, H01L 25/16, H10H 29/851, H10H 20/825, H10H 20/824, H10H 29/852

(54) **DISPOSITIF OPTOÉLECTRONIQUE ET SON PROCÉDÉ DE FABRICATION**
OPTOELEKTRONISCHE VORRICHTUNG UND VERFAHREN ZU DEREN HERSTELLUNG
OPTOELECTRONIC DEVICE AND METHOD OF MANUFACTURING THE SAME

(30) Priorité: 29.09.2023 FR 2310409
(43) Date de publication de la demande: 02.04.2025
(73) Titulaire: Aledia, 38130 Echirolles (FR)
(72) Inventeur: LUDURCZAK, Willy, 69006 Lyon (FR); POURQUIER, Eric, 38000 Grenoble (FR)
(74) Mandataire: Hautier IP

(56) Documents cités:
- US-A1- 2017 309 798
- US-A1- 2019 302 917
- US-A1- 2022 352 441

## Description

### DOMAINE TECHNIQUE

La présente invention concerne le domaine des technologies pour la microélectronique et l'optoélectronique. Elle trouve pour application particulièrement avantageuse la fabrication de dispositifs optoélectroniques, notamment des pixels à base de diodes électroluminescentes (LEDs).

### ÉTAT DE LA TECHNIQUE

Un écran d'affichage auto-émissif est un exemple de dispositif optoélectronique comprenant une pluralité de pixels émettant leur propre lumière. Chaque pixel est typiquement formé par plusieurs LEDs ou micro-LEDs.

Le document US 2017/0309798 A1 décrit un écran LED à haute luminosité et faible consommation d'énergie. Ce document décrit, plus particulièrement, un micro-écran à LEDs intégrées ainsi que son procédé de fabrication impliquant, notamment, une couche organique de collage.

Un pixel comprend généralement au moins trois sous-pixels émettant chacun un rayonnement de couleur différente, classiquement dans le vert, le rouge et le bleu. Les sous-pixels RGB (acronyme de « Red Green Blue ») peuvent être obtenus en ajoutant des modules de conversion de couleur différents au-dessus de LEDs semblables. Ainsi, pour former un pixel, il est par exemple possible d'utiliser trois LEDs émettant uniquement dans le bleu, et de disposer un module de conversion du bleu vers le rouge et un autre module de conversion du bleu vers le vert au-dessus de deux LEDs parmi les trois LEDs bleues. Cela évite de former ou de reporter localement différents types de LEDs. Cette solution permet typiquement de minimiser les coûts de fabrication d'un écran auto-émissif.

Selon une possibilité, ces LEDs sont des LEDs dites intelligentes appelées « smart LEDs », comprenant typiquement une structure optiquement active connectée à une électronique de pilotage dédiée, à base de transistors. Des groupes de smart LEDs connectés à des électroniques de commande indépendantes, forment typiquement des « smart pixels ».

Le dispositif optoélectronique peut ainsi comprendre une couche de conversion de couleur agencée sur une couche émettrice et/ ou une couche d'électronique sous la couche émettrice avec des interconnexions entre la couche d'électronique et la couche émettrice.

Pour protéger les composants et les manipuler, et/ou pour améliorer l'efficacité d'extraction de lumière, une couche de verre épaisse est formée au-dessus de la couche émettrice comprenant éventuellement une couche de conversion de couleur. Des procédés d'assemblage sont déjà connus pour assembler cette couche de verre épaisse, sous forme d'un substrat verre transparent, avec des sous-pixels RGB comprenant par exemple des modules de conversion de couleur.

Un premier exemple de procédé d'assemblage de type « SiOx/SiOx bonding » permet de coller deux surfaces, chacune recouverte d'une couche de SiOx. Un inconvénient de cette solution est que dans ce procédé d'assemblage, une étape requiert un recuit de consolidation, par exemple à 200°C pendant 2 heures, pour former une couche de liaison entre les couches SiOx/SiOx. Avantageusement, cette couche de liaison est transparente pour le passage de l'émission de lumière, néanmoins, une telle étape de recuit est néfaste pour des modules de conversion de couleur qui sont des composants sensibles à une telle température. Ces modules de conversion de couleur peuvent être dégradés sous l'action d'une température trop élevée et ainsi voir leur efficacité de conversion diminuer.

Une étape de recuit de consolidation telle que décrite ci-dessus dans un procédé d'assemblage de type SiOx/SiOx bonding peut également être néfaste pour un dispositif optoélectronique comprenant une couche d'électronique sensible à la température préalablement agencée sous une couche émettrice (du côté opposé au passage de l'émission de lumière). En effet, si cette couche d'électronique correspond à un substrat à base de silicium portant des transistors, par exemple des transistors en couche mince TFT (acronyme de « Thin Film Transistor ») de type IGZO (acronyme de « Indium Gallium Zinc Oxide »), ces derniers ne supportent généralement pas une température excédant 150°C.

Un autre exemple d'assemblage peut se faire via une couche de liaison à base de colle organique transparente, activée sous UV. Un inconvénient de cette solution est que la couche de liaison présente des propriétés mécaniques peu satisfaisantes, engendrant notamment des problèmes de dilatation et de déformation. La fiabilité et la résistance du dispositif optoélectronique sont altérées. Un autre inconvénient de cette solution, qui comprend une étape d'activation UV, est qu'il n'est pas possible d'utiliser des substrats verre opacifiés avant l'assemblage. Or les substrats verre transparents sont difficilement manipulables par les automates de l'industrie microélectronique, qui recourent généralement à une détection optique pour la manipulation et le positionnement des substrats. Cette solution n'est donc pas pleinement compatible avec les procédés industriels standards de la microélectronique. Un autre inconvénient de cette solution est que la couche de liaison à base de colle organique transparente ne permet pas d'empêcher une exposition des modules de conversion de couleur à l'oxygène. La durée de vie des modules de conversion de couleur est ainsi réduite.

Il existe donc un besoin consistant à améliorer le procédé d'assemblage d'une couche transparente sur une structure comprenant une couche de composants sensibles à la température et/ou aux conditions environnantes, notamment à une atmosphère oxydante. Un objet de la présente invention est de répondre à ce besoin en palliant au moins en partie les inconvénients des solutions connues.

En particulier, un objet de la présente invention est de proposer un dispositif optoélectronique comprenant une couche de composants sensibles à la température et une couche de support transparente, qui soit fiable et compatible avec les procédés de fabrication de la microélectronique. Un autre objet de la présente invention est de proposer un procédé de fabrication d'un tel dispositif optoélectronique.

Les autres objets, caractéristiques et avantages de la présente invention apparaîtront à l'examen de la description suivante et des dessins d'accompagnement. Il est entendu que d'autres avantages peuvent être incorporés. En particulier, certaines caractéristiques et certains avantages du dispositif peuvent s'appliquer *mutatis mutandis* au procédé, et réciproquement.

### RÉSUMÉ DE L'INVENTION

Pour atteindre les objectifs mentionnés ci-dessus, la présente invention concerne, dans un premier aspect, un dispositif optoélectronique, selon la revendication 1 en annexe, comprenant en empilement selon une direction z :
- au moins une couche émettrice comprenant des structures optiquement actives, configurées pour émettre ou recevoir un rayonnement selon une longueur d'onde λ,
- une couche de liaison,
- une couche de support transparente,

le dispositif optoélectronique comprenant en outre, dans l'empilement selon la direction z, au moins une couche dite sensible comprenant au moins une structure dite sensible présentant une résistance en température inférieure à une température Tmax,
le dispositif optoélectronique étant caractérisé en ce que la couche de liaison est à base d'un matériau de collage inorganique basse température, et en ce que la couche de liaison comprend des cavités à l'aplomb des structures optiquement actives, entre la couche de support transparente et la couche émettrice comprenant lesdites structure optiquement actives.

Selon la présente invention, la couche de liaison est donc à base d'un matériau de collage inorganique dit « basse température », c'est-à-dire pouvant être mis en œuvre à une température ne dégradant pas l'au moins une structure sensible à la température. Les propriétés mécaniques d'un tel matériau de collage, qui est compatible avec la présence de l'au moins une structure sensible à la température, sont plus appropriées pour un dispositif optoélectronique qu'une colle organique généralement utilisée dans les solutions connues. La tenue mécanique est améliorée. La résistance au vieillissement du dispositif est améliorée. La fiabilité du dispositif est supérieure à celle des dispositifs connus. Un tel matériau de collage inorganique basse température est cependant généralement opaque.

Selon la présente invention, la couche de liaison comprend des cavités à l'aplomb des structures optiquement actives, entre la couche de support transparente et la couche émettrice comprenant les structures optiquement actives. Ces cavités au-dessus des structures optiquement actives permettent un passage optique au travers de la couche de liaison. Ainsi, la couche de liaison en un matériau de collage inorganique basse température n'empêche pas l'émission ou la réception de lumière vers les structures optiquement actives.

Selon un exemple, la couche dite sensible est agencée entre la couche émettrice comprenant les structures optiquement actives et la couche de liaison, l'au moins une structure dite sensible étant un module convertisseur de couleur.

Selon un autre exemple, la couche dite sensible est portée par un substrat agencé sous la couche émettrice comprenant les structures optiquement actives, du côté opposé à la couche de liaison. L'au moins une structure dite sensible étant un transistor, de préférence un transistor en couche mince.

Selon un exemple, le dispositif comprend une première couche sensible agencée entre la couche émettrice et la couche de liaison, et une deuxième couche sensible agencée entre un substrat et la couche émettrice comprenant les structures optiquement actives, du côté opposé à la couche de liaison. Les structures optiquement actives sont typiquement des diodes électroluminescentes. La première couche sensible comprend typiquement au moins une première structure sensible telle qu'un module convertisseur de couleur. La deuxième couche sensible comprend typiquement au moins une deuxième structure sensible telle qu'un transistor, de préférence un transistor en couche mince.

Selon un exemple, la couche de liaison forme des bandes de collage qui délimitent les cavités.

Chaque cavité forme typiquement un espace clos hermétique enfermant le module convertisseur de couleur de sorte qu'il ne soit pas en contact avec les conditions environnantes au dispositif. Cela permet de limiter la dégradation du module convertisseur de couleur. Cela permet de préserver son efficacité de conversion.

Selon un mode de réalisation, les cavités présentent une pression inférieure à la pression atmosphérique, de préférence au moins une décade inférieure à la pression atmosphérique. Avantageusement, les cavités sont hermétiquement fermées, limitant tout phénomène d'oxydation du module de conversion de couleur.

Ainsi, contrairement aux solutions connues basées sur des couches de liaison continues transparentes (à base de colles organiques ou de type SiOx/SiOx bonding), le dispositif optoélectronique selon la présente invention comprend une couche de liaison inorganique structurée. Contrairement à un préjugé technique, la structuration de la couche de liaison ne compromet pas l'assemblage entre la couche de support transparente et la couche émettrice comprenant les structures optiquement actives ou entre la couche de support transparente et la couche sensible lorsque celle-ci est présente entre la couche émettrice comprenant les structures optiquement actives et le support transparent. L'utilisation d'un matériau de collage inorganique basse température permet de compenser ou surpasser la diminution de tenue mécanique liée à la structuration de la couche de liaison. Le dispositif optoélectronique comprenant une couche de liaison inorganique structurée selon l'invention présente ainsi une tenue mécanique typiquement supérieure ou égale à celle d'un dispositif connu comprenant une couche de liaison continue organique. Un tel dispositif présente en outre une compatibilité accrue avec les technologies de la microélectronique. En particulier, une couche de liaison inorganique est moins critique qu'une couche à base de colle organique en termes de contamination des équipements lors du procédé de fabrication du dispositif. Le dispositif selon l'invention est ainsi plus facile et/ou moins coûteux à fabriquer par les procédés standards de l'industrie microélectronique.

Selon un mode de réalisation, le matériau de collage inorganique peut être opaque. Avantageusement, la couche de liaison, en dehors des cavités, ne laisse pas passer le rayonnement émis ou reçu. La zone d'émission ou de réception est ainsi indirectement cloisonnée par le passage à travers les cavités.

Un autre aspect de la présente invention concerne un procédé de fabrication, selon la revendication 13 en annexe, d'un tel dispositif optoélectronique Le procédé selon la présente invention comprend au moins les étapes suivantes :
- fournir un empilement comprenant au moins une couche émettrice comprenant des structures optiquement actives, configurées pour émettre ou recevoir un rayonnement selon une longueur d'onde λ, et au moins une couche dite sensible comprenant des structures dites sensibles présentant une résistance en température inférieure à une température Tmax,
- former, sur l'empilement, une première partie de couche de liaison à base d'un matériau de collage inorganique basse température, ladite première partie comportant des premières ouvertures à l'aplomb des structures optiquement actives,
- fournir une couche de support transparente,
- former, sur une première face de la couche de support transparente, une deuxième partie de couche de liaison à base du matériau de collage inorganique basse température, ladite deuxième partie comportant des deuxièmes ouvertures configurées pour être mises en correspondance avec les premières ouvertures,
- mettre en regard la deuxième partie de couche de liaison avec la première partie de couche de liaison,
- assembler l'empilement comprenant la couche sensible avec la couche de support transparente par collage basse température entre les première et deuxième parties de couche de liaison, les premières et deuxièmes ouvertures formant alors des cavités à l'aplomb des structures optiquement actives.

Ainsi, le procédé permet de fabriquer le dispositif optoélectronique décrit ci-dessus.

De façon préférée, le procédé comprend en outre une opacification d'une deuxième face de la couche de support transparente avant mise en regard des première et deuxième parties de couche de liaison, et un retrait de la deuxième face opacifiée après assemblage de l'empilement comprenant la couche sensible avec la couche de support transparente. L'opacification avant assemblage permet avantageusement d'utiliser les équipements et les automates de l'industrie microélectronique recourant à des détections optiques de substrats. La couche de support opacifiée présente en outre une résistance accrue vis-à-vis des procédés plasma ou de nettoyages et des procédés de gravures humides. Le coût du procédé de fabrication est ainsi diminué.

### BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :

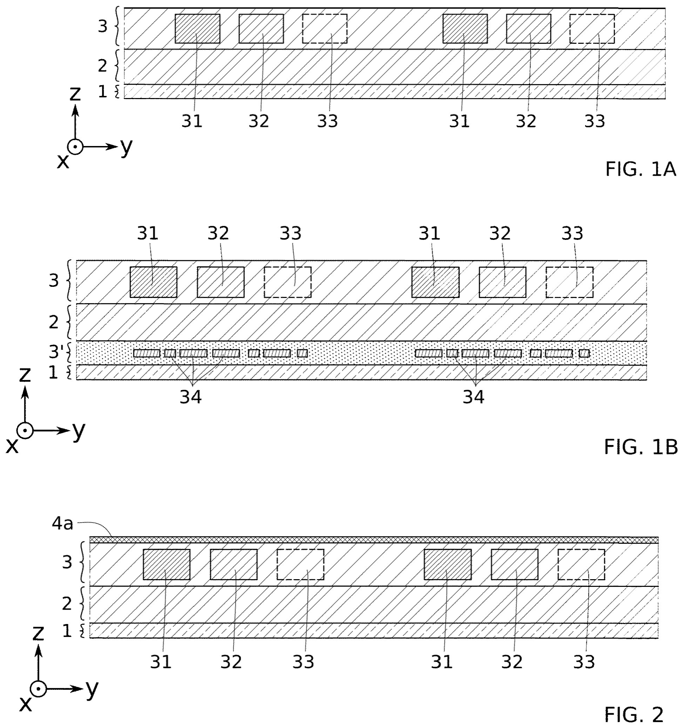

Les figures 1A à 8 illustrent schématiquement des étapes de fabrication d'un dispositif optoélectronique selon un mode de réalisation de la présente invention. Les figures notées respectivement A et B, précédées d'un même chiffre, illustrent schématiquement deux variantes du procédé de fabrication selon la présente invention, pour une même étape.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les dimensions des différents éléments constitutifs des couches émettrices ne sont pas forcément représentatives de la réalité.

### DESCRIPTION DÉTAILLÉE

Avant d'entamer une revue détaillée de modes de réalisation de l'invention, il est rappelé que l'invention peut notamment comprendre les caractéristiques optionnelles ci-après, tant du moins qu'elles demeurent sous l'étendue des présentes revendications en annexe, pouvant être utilisées en association ou alternativement :
Selon un exemple, l'empilement des couches selon z suit l'ordre suivant :
   - la couche émettrice comprenant les structures optiquement actives,
   - la couche sensible comprenant au moins une structure sensible,
   - la couche de liaison,
   - la couche de support transparente.
Selon un autre exemple, l'empilement des couches selon z suit l'ordre suivant :
   - la couche sensible comprenant au moins une structure sensible,
   - la couche émettrice comprenant les structures optiquement actives,
   - la couche de liaison,
   - la couche de support transparente.
Selon un autre exemple, l'empilement des couches selon z suit l'ordre suivant :
   - une première couche sensible comprenant au moins une première structure sensible,
   - la couche émettrice comprenant les structures optiquement actives,
   - une seconde couche sensible comprenant au moins une seconde structure sensible,
   - la couche de liaison,
   - la couche de support transparente.

Selon un exemple, les structures optiquement actives sont des diodes électroluminescentes. La couche émettrice, comprenant ces structures optiquement actives, est typiquement formée dans un matériau semiconducteur dopé ou non. Il peut être formé en saphir voire en un matériau à base de composés III-V, par exemple du GaN, GaAs ou InP. Il peut alternativement s'agir d'un substrat de type silicium, ou d'un substrat de type silicium sur isolant ou « SOI » pour « Silicon On Insulator » selon la terminologie anglo-saxonne consacrée.

Selon un exemple, l'au moins une structure sensible de la couche sensible est un module convertisseur de couleur.

Selon un exemple, l'au moins un module convertisseur de couleur comprend des boîtes quantiques.

Selon un exemple, l'au moins une structure sensible de la couche sensible est un transistor, de préférence un transistor en couche mince.

Selon un exemple, le matériau de collage basse température inorganique est opaque.

Selon un exemple, le matériau de collage basse température inorganique est à base de métal ou de métal amorphe ou de silicium amorphe ou germanium amorphe. Selon un exemple, le matériau de collage basse température inorganique est à base de titane. Selon un exemple, la couche de liaison comprend une sous-couche à base de titane et une couche à base de silicium amorphe.

Selon un exemple, la température Tmax est inférieure à 180°C, de préférence inférieure à 150°C. Selon un exemple, la couche de liaison présente une épaisseur comprise entre 3 nm et 100 nm, de préférence entre 5 nm et 10 nm.

Selon un exemple, les cavités présentent une pression inférieure à la pression atmosphérique, de préférence au moins une décade inférieure à la pression atmosphérique. Cela implique en particulier que les cavités soient hermétiques. Ainsi, dans le cas où la couche sensible est agencée entre la couche émettrice comprenant les structures optiquement actives et la couche de liaison, les structures de la couche sensible ne sont pas soumises à une atmosphère humide ou oxydante. Les structures de la couche sensible se dégradent moins vite dans le temps. Le vieillissement du dispositif est ralenti.

Selon un exemple, la couche de support transparente est à base de verre.

Selon un exemple, les cavités sont transparentes au rayonnement émis ou reçu par les structures optiquement actives.

Selon un exemple, la couche de liaison est formée par un assemblage de première et deuxième parties du matériau de collage inorganique, déposées respectivement sur la couche émettrice comprenant les structures optiquement actives (ou la couche sensible lorsque présente entre la couche émettrice comprenant les structures optiquement actives et la couche de liaison) et sur une face de la couche de support transparente.

Selon un exemple, l'au moins une couche émettrice comprenant les structures optiquement actives est à base de GaN ou de GaAs.

Selon un exemple, l'assemblage par collage basse température est effectué à une température Tc inférieure à la température Tmax, de préférence telle que Tc ≤ Tmax - 20°C, de préférence telle que Tc ≤ Tmax - 50°C. Tc et Tmax s'expriment en degrés Celsius (°C). L'assemblage est configuré pour coller la couche de support transparente à la couche sensible en préservant les structures sensibles.

Selon un exemple, la température Tmax correspond à une température au-delà de laquelle les structures sensibles se dégradent thermiquement.

Selon un exemple, l'assemblage par collage basse température est effectué à température ambiante ou à environ 20°C. Avantageusement, ce type d'assemblage ne nécessite pas de post traitement, ce qui n'est pas le cas d'un collage polymère qui requiert une activation par UV pouvant endommager les structures sensibles. Ce n'est pas non plus le cas d'un collage hydrophile oxyde/oxyde qui requiert un recuit de consolidation pouvant endommager les structures sensibles.

Selon un exemple, le procédé comprend en outre une opacification d'une deuxième face de la couche de support transparente avant mise en regard des première et deuxième parties de couche de liaison, et un retrait de la deuxième face opacifiée après assemblage de l'empilement comprenant la couche sensible avec la couche de support transparente. L'opacification permet une manipulation facilitée de la couche de support transparente, notamment par les équipements et automates à détection optique de l'industrie microélectronique. Avantageusement, l'assemblage par collage basse température ne requiert pas que la couche de support soit transparente lors de l'assemblage, contrairement à un collage organique activé par UV.

Selon un exemple, l'opacification est effectuée sans limitation de température, typiquement à une température To supérieure à Tmax. L'opacification est typiquement réalisée séparément, avant l'assemblage. L'opacification peut donc être effectuée sans restriction de température, notamment à des températures supérieures à 200°C. L'opacification consiste à déposer au moins une couche opaque, généralement un métal, Ti ou TiN par exemple, éventuellement encapsulé par un diélectrique. Une opacification par dépôt d'une telle couche opaque est plus robuste vis-à-vis des traitements ultérieurs de nettoyage ou de retrait humides à base de HF, et peut avantageusement être mise en œuvre dans le cadre du procédé de fabrication du dispositif.

Selon un exemple, l'assemblage par collage basse température est effectué sous une pression Pc inférieure à la pression atmosphérique Patm, de préférence telle que Pc ≤ 10⁻³.Patm, et de préférence telle que Pc ≤ 10⁻⁸.Patm. La pression Pc est par exemple de l'ordre de 5.10⁻⁶ Patm. Le collage basse température est typiquement effectué sous vide ou sous ultra vide. Cela permet de conserver des liaisons pendantes après décapage de l'oxyde natif pour des parties de couche de liaison à base de silicium amorphe. La qualité du collage est améliorée. En conséquence, les cavités ainsi réalisées sont étanches et sous vide. Cela permet de protéger les structures sensibles qui sont hermétiquement fermées vis-à-vis d'une atmosphère humide ou oxydante.

Selon un exemple, le matériau de collage basse température inorganique est choisi à base de métal ou de métal amorphe ou de silicium amorphe. Selon un exemple, le matériau de collage basse température inorganique est choisi à base de germanium amorphe.

Selon un exemple, les premières et deuxièmes ouvertures sont formées de manière symétrique dans les première et deuxième parties de couche de liaison. Cela permet de mieux répartir les efforts mécaniques entre la couche de liaison, la couche de support et la couche sensible. La distribution des contraintes mécaniques est plus homogène. Les contraintes mécaniques dans le dispositif sont potentiellement limitées. Les premières et deuxièmes ouvertures formées de manière symétrique n'impliquent pas nécessairement que les première et deuxième parties de couche de liaison sont d'égales épaisseurs.

Selon un exemple, la première partie de couche de liaison est d'abord formée en continu sur la couche sensible de l'empilement, puis les premières ouvertures sont formées dans la première partie de couche de liaison.

Selon un exemple, la deuxième partie de couche de liaison est d'abord formée en continu sur la première face de la couche de support transparente, puis les deuxièmes ouvertures sont formées dans la deuxième partie de couche de liaison.

Sauf incompatibilité, des caractéristiques techniques décrites en détail pour un mode de réalisation donné peuvent être combinées aux caractéristiques techniques décrites dans le contexte d'autres modes de réalisation décrits à titre exemplaire et non limitatif, de manière à former un autre mode de réalisation qui n'est pas nécessairement illustré ou décrit. Un tel mode de réalisation n'est évidemment pas exclu de l'invention.

On entend par « dispositif optoélectronique » un dispositif apte à émettre, véhiculer, ou recevoir de la lumière. Selon une application particulière, un tel dispositif optoélectronique comprend des diodes électroluminescentes (LEDs), en particulier des LEDs formant les sous-pixels d'un pixel d'écran émissif.

L'invention peut être mise en œuvre plus largement pour différents dispositifs optoélectroniques. L'invention peut par exemple être mise en œuvre dans le cadre de dispositifs laser ou photovoltaïque.

Les LEDs ou dispositifs optoélectroniques présentent typiquement dans le cadre de la présente invention des dimensions, en projection dans un plan de base xy, inférieures à 100 µm X 100 µm, de préférence inférieures à 10 µm X 10 µm.

Sauf mention explicite, il est précisé que, dans le cadre de la présente invention, la disposition relative d'une deuxième couche intercalée entre une première couche et une troisième couche, ne signifie pas obligatoirement que les couches sont directement au contact les unes des autres, mais signifie que la deuxième couche est soit directement au contact des première et troisième couches, soit séparée de celles-ci par au moins une autre couche ou au moins un autre élément. Ainsi, les termes et locutions « prendre appui », « surmonter », « couvrir » ou « recouvrir » ne signifient pas nécessairement « au contact de ».

Les étapes du procédé telles que revendiquées s'entendent au sens large et peuvent éventuellement être réalisées en plusieurs sous-étapes.

Dans la présente demande de brevet, les termes « diode électroluminescente », « LED » ou simplement « diode » sont employés en synonymes. Une « LED » peut également s'entendre d'une « micro-LED » ou d'une « smart LED ».

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi, une diode à base de GaN comprend typiquement du GaN et des alliages d'AlGaN ou d'InGaN.

Un repère, de préférence orthonormé, comprenant les axes x, y, z est représenté sur certaines figures annexées. Ce repère est applicable par extension aux autres figures.

Dans la présente demande de brevet, on parlera préférentiellement d'épaisseur pour une couche et de hauteur pour une structure ou un dispositif. L'épaisseur est prise selon une direction normale au plan d'extension principal de la couche, et la hauteur est prise perpendiculairement au plan de base xy. Ainsi, une couche présente typiquement une épaisseur selon z, lorsqu'elle s'étend principalement le long d'un plan xy, et un élément en saillie, par exemple un module de conversion de couleur, présente une hauteur selon z. Les termes relatifs « sur », « sous », « sous-jacent » se réfèrent préférentiellement à des positions prises selon la direction z. Dans la présente demande, « vertical », « verticalement » signifient « dirigé selon la direction z » et « latéral », « latéralement » signifient « dirigé selon une direction du plan xy ».

Dans le cadre de la présente invention, un objet ou un matériau « transparent » signifie que l'objet ou le matériau laisse passer au moins 90% de l'intensité lumineuse du faisceau lumineux qui le traverse. A contrario, un matériau ou une surface est considérée comme « opaque » dès lors qu'elle absorbe ou stoppe au moins 85% de l'intensité d'un faisceau lumineux incident.

On entend par « résistance en température » d'une structure la température maximale à laquelle l'intégrité de la structure n'est pas thermiquement dégradée.

On entend par « matériau de collage inorganique basse température » un matériau inorganique pouvant être utilisé dans un procédé de collage basse température, c'est-à-dire mis en œuvre à une température inférieure à 200°C, de préférence à une température inférieure à 180°C, et de préférence à une température inférieure à 150°C. Le matériau de collage inorganique basse température est typiquement mis en œuvre à température ambiante, sans nécessité de recuit de consolidation.

Les valeurs dimensionnelles s'entendent aux tolérances de fabrication et de mesure près.

Les termes « sensiblement », « environ », « de l'ordre de » signifient, lorsqu'ils se rapportent à une valeur, « à 10% près » de cette valeur ou, lorsqu'ils se rapportent à une orientation angulaire, « à 10° près » de cette orientation. Ainsi, une direction sensiblement normale à un plan signifie une direction présentant un angle de 90±10° par rapport au plan.

Les figures 1A à 8 illustrent des étapes de réalisation d'un dispositif optoélectronique comprenant des structures optiquement actives surmontées par une couche sensible 3 et une couche de support transparente.

Dans cet exemple de réalisation, les structures optiquement actives sont des LEDs à base de GaN configurées pour émettre un rayonnement lumineux à une première longueur d'onde λ1 dans le bleu ou dans l'UV. Ces LEDs sont typiquement portées par un substrat à base de GaN et encapsulées pour former la couche émettrice 2. Les LEDs peuvent présenter une architecture planaire (2D) au sein de la couche émettrice 2. Dans ce cas, chaque LED peut comprendre une pluralité de couches superposées selon z. Un tel empilement de couches comprend typiquement une couche active intercalée entre une couche d'injection d'électrons et une couche d'injection de trous. La couche active émet le rayonnement lumineux de longueur d'onde λ1 par recombinaison radiative des électrons et des trous. Selon une autre possibilité, les LEDs peuvent présenter une architecture tridimensionnelle (3D) au sein de la couche émettrice 2. Dans ce cas, chaque LED peut comprendre un ensemble de nanopyramides et/ou nanofils semiconducteurs de préférence principalement dirigés selon z, noyés dans une matrice à base d'un matériau diélectrique. Les nanofils semiconducteurs comprennent typiquement chacun une région active intercalée entre une région d'injection d'électrons et une région d'injection de trous. La région active émet le rayonnement lumineux de longueur d'onde λ1 par recombinaison radiative des électrons et des trous. La couche sensible 3 est une couche comprenant des structures sensibles à la température. Dans cet exemple de réalisation, la couche sensible 3 comprend des modules de conversion de couleurs 31, 32, 33. Un module de conversion de couleur peut être par exemple sous forme d'un bloc photoluminescent diffusant comprenant des luminophores, ou un bloc photoluminescent comprenant des particules d'au moins un matériau photoluminescent, dispersées par exemple dans une matrice transparente (i.e. résine photosensible). Les luminophores sont configurés, lorsqu'ils sont excités par la lumière émise par les diodes électroluminescentes, pour émettre de la lumière à une longueur d'onde différente de la longueur d'onde de la lumière émise par les diodes électroluminescentes. Les particules photoluminescentes peuvent se présenter sous la forme de boîtes quantiques (quantum dots en anglais), c'est-à-dire sous la forme de nanocristaux semiconducteurs dont le confinement quantique est sensiblement tridimensionnel. Les boîtes quantiques peuvent être formées d'au moins un composé semiconducteur, qui peut être choisi parmi le séléniure de cadmium (CdSe), le phosphore d'indium (InP), le phosphore de gallium et d'indium (InGaP), le sulfure de cadmium (CdS), le sulfure de zinc (ZnS), l'oxyde de cadmium (CdO) ou de zinc (ZnO), le séléniure de zinc et de cadmium (CdZnSe), le séléniure de zinc (ZnSe) dopé par exemple au cuivre ou au manganèse, le graphène ou parmi c'est-à-dire autres matériaux semiconducteurs pouvant convenir. Les boîtes quantiques peuvent également présenter une structure de type cœur/ coquille, tel que CdSe/ ZnS, CdSe/ CdS, CdSe/ CdS/ZnS, PbSe/ PbS, CdTe/ CdSe, CdSe/ ZnTe, InP/ZnS ou autre. La taille et/ ou la composition des particules photoluminescentes sont choisies en fonction de la longueur d'onde de luminescence désirée.

Un autre exemple d'un matériau photoluminescent est le grenat d'yttrium et d'aluminium (YAG) activé par l'ion cérium trivalent, également appelé YAG:Ce ou YAG:Ce³⁺. Typiquement, un bloc photoluminescent comprend une matrice d'un matériau inorganique ou organique dans laquelle sont éventuellement dispersées des particules monocristallines de taille nanométrique d'un matériau semiconducteur, également appelées nanocristaux semiconducteurs ou particules de nanoluminophores. Les modules de conversion de couleurs 31, 32, 33 surmontent les LEDs de la couche émettrice 2. Ici, les modules de conversion de couleurs 31, 32 sont configurés pour convertir la première longueur d'onde A1 issue des LEDs en une autre longueur d'onde. Typiquement, le module de conversion de couleur 31 est configuré pour convertir la première longueur d'onde λ1 en une deuxième longueur d'onde λ2 dans le rouge. Le module de conversion de couleur 32 est configuré pour convertir la première longueur d'onde λ1 en une troisième longueur d'onde λ3 dans le vert. De façon schématique, pour former un pixel, au moins trois sous-pixels vert, rouge, bleu sont requis. Ainsi, pour obtenir le sous-pixel bleu (dans la gamme de 430nm à 490nm), il suffit de transmettre la première longueur d'onde λ1 issue d'une première LED située sous l'emplacement 33. Pour obtenir le sous-pixel rouge (dans la gamme de 580nm à 700nm), le module de conversion de couleur 31 est placé au-dessus d'une deuxième LED. Pour obtenir le sous-pixel vert (dans la gamme de 500nm à 560nm), le module de conversion de couleur 32 est placé au-dessus d'une troisième LED. Ces modules de conversion de couleurs 31, 32 sont intégrés au sein d'une couche transparente, par exemple à base d'oxyde de silicium. Cette couche 3 placée au-dessus de la couche émettrice 2, est une couche sensible à la température. Elle est également appelée « couche de conversion » 3 dans la suite. Les modules de conversion de couleurs 31, 32 se dégradent par exemple au-delà de 150°C environ. Pour préserver la fonctionnalité/intégrité et les performances de ces modules de conversion de couleurs 31, 32, les étapes de fabrication suivantes impliquant la couche sensible 3 ne doivent pas excéder 150°C. Selon une possibilité, la première longueur d'onde λ1 issue des LEDs appartient au domaine UV, et trois modules de conversion de couleur 31, 32, 33 sont utilisés pour convertir la première longueur d'onde λ1 respectivement en une longueur d'onde dans le rouge, dans le vert et dans le bleu.

Selon une possibilité préférée, des groupes de LEDs de la couche émettrice 2 sont connectés à des électroniques de commande indépendantes pour former des « smart pixels ». Le dispositif optoélectronique peut ainsi comprendre une couche d'électronique sous la couche émettrice 2. Cette couche d'électronique peut correspondre à un substrat 1 à base de silicium portant des transistors, par exemple des transistors métal-oxyde-semiconducteur complémentaires CMOS ou des transistors en couche mince (TFT, acronyme de « Thin Film Transistor »), par exemple de type LTPS (acronyme de « « Low-temperature polycrystalline silicon »), ou de type IGZO (acronyme de « Indium Gallium Zinc Oxide »), ces derniers ne supportent généralement pas une température excédant 150°C. Ainsi, la couche d'électronique peut être par la suite dite couche 3' sensible comprenant au moins une structure dite sensible, la structure dite sensible correspondant par exemple à un transistor en couche mince.

Des interconnexions entre la couche d'électronique 3' et la couche émettrice 2 sont typiquement présentes. Un tel assemblage permet de réaliser des LEDs dites intelligentes appelées « smart LEDs ». Une smart LED comprend typiquement une structure optiquement active connectée à une électronique de pilotage dédiée, à base de transistors.

La figure 1A illustre ici une première partie du dispositif optoélectronique comprenant, en empilement selon z, un substrat 1 par exemple à base de silicium, une couche émettrice 2 par exemple à base de GaN, et une couche de conversion 3 sensible en température. La figure 1B illustre en variante une première partie du dispositif optoélectronique comprenant, en empilement selon z, un substrat 1 portant une couche d'électronique 3' comprenant des transistors 34 sensibles ou non en température, une couche émettrice 2, et une couche de conversion 3 sensible en température.

Les étapes suivantes de fabrication du dispositif optoélectronique visent à former par assemblage une couche de support transparente sur la couche de conversion 3.

Comme illustré à la figure 2, une première partie 4a de couche de liaison est formée en continu sur la couche de conversion 3. Cette première partie 4a de couche de liaison est à base d'un matériau de collage basse température inorganique, par exemple un métal et/ou du silicium amorphe ou du germanium amorphe. La formation de cette première partie 4a de couche de liaison est effectuée à basse température afin de préserver les structures 31, 32, 33 de la couche de conversion 3, Un exemple de dépôt basse température de silicium amorphe, à des températures de 75°C et 100°C, est divulgué dans le document « Low-temperature deposition of amorphous silicon solar cells, C. Koch et al., Solar Energy Materials and Solar Cells, Volume 68, Issue 2, May 2001, Pages 227-236 ». Ce matériau de collage basse température inorganique est typiquement opaque. Dans le cadre du développement de la présente invention, il a été identifié que l'absorption due à l'opacité du matériau de collage inorganique n'est pas significative, lorsqu'il s'agit par exemple d'une interface en silicium épaisse de 10nm. En revanche, il est apparu que la réflexion engendrée par la couche de liaison diminue drastiquement l'émission des structures sous-jacentes. La solution qui a été développée consiste à former des ouvertures dans la couche de liaison, au-dessus des zones d'émission des couches 2, 3, pour éviter en particulier les réflexions parasites.

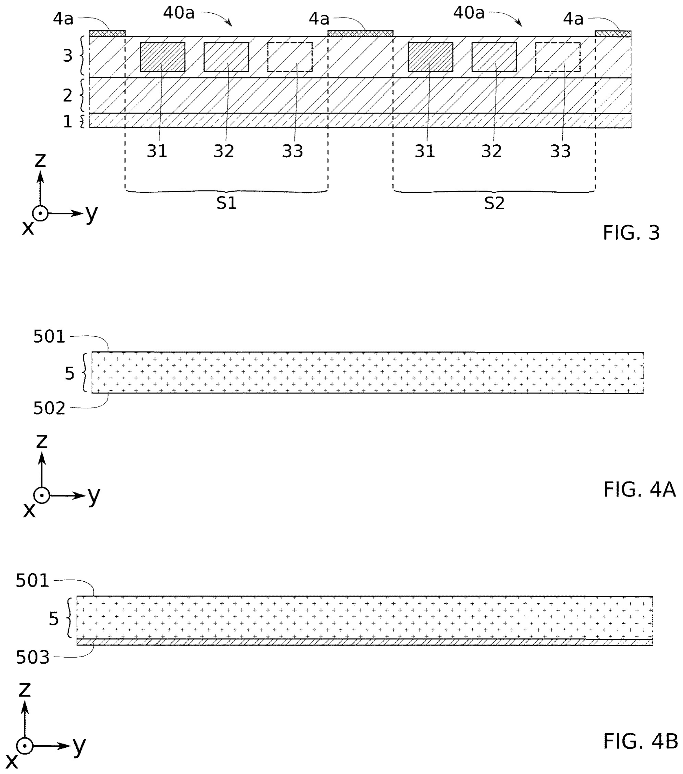

Comme illustré à la figure 3, des premières ouvertures 40a sont formées de manières connues, typiquement par lithographie et gravure, dans la première partie 4a de couche de liaison, au-dessus des zones d'émission S1, S2 des couches d'émission 2 et de conversion 3. La couche 3 est exposée au travers des premières ouvertures 40a.

La figure 4A illustre une couche de support transparente 5 sous forme de substrat en verre, présentant une première face 501 et une deuxième face 502. Cette couche de support transparente 5 est fournie indépendamment de l'empilement de couches électronique, d'émission 2, de conversion 3.

Selon une possibilité préférée illustrée à la figure 4B, la couche de support transparente 5 est préalablement opacifiée au niveau d'une face, par exemple par dépôt d'une couche opaque métallique 503 sur la face. A ce stade, l'opacification peut être réalisée sans limitation de température, séparément du reste de l'empilement de couches électroniques, d'émission 2, de conversion 3. Cela permet de mettre en œuvre des procédés d'opacification robustes, avec une opacification résistante aux traitements de nettoyage chimiques ou aux procédés de retraits de résines utilisées en photolithographie. La couche de support transparente 5 opacifiée peut être facilement manipulée par les automates des équipements de l'industrie microélectronique, qui recourent à la détection optique.

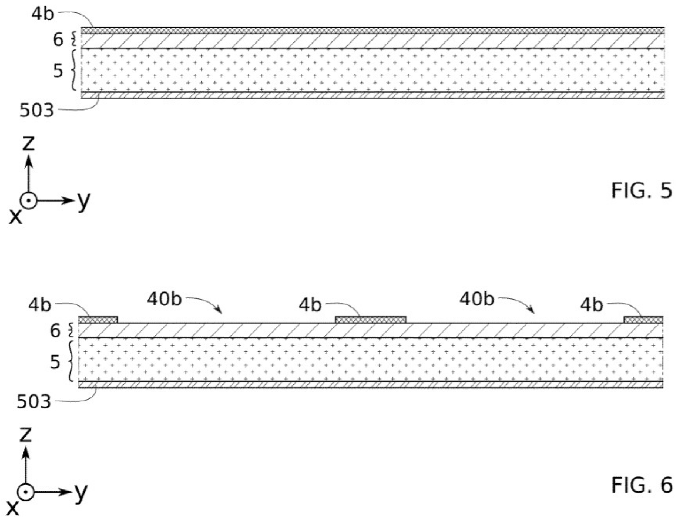

Comme illustré à la figure 5, de façon optionnelle, une couche 6 transparente à base d'oxyde de silicium peut être déposée sur la face de la couche de support transparente 5 opposée à la face opacifiée 503. Une planarisation par polissage mécano-chimique CMP peut ensuite être réalisée pour obtenir un état de surface adapté au dépôt d'une deuxième partie 4b de couche de liaison. La deuxième partie 4b de couche de liaison est typiquement à base du même matériau de collage basse température inorganique que la première partie 4a de couche de liaison. Elle est par exemple à base de silicium amorphe. Les première et deuxième partie 4a, 4b de couche de liaison présentent typiquement des rugosités Ra < 1 nm, préférablement Ra < 0,5 nm.

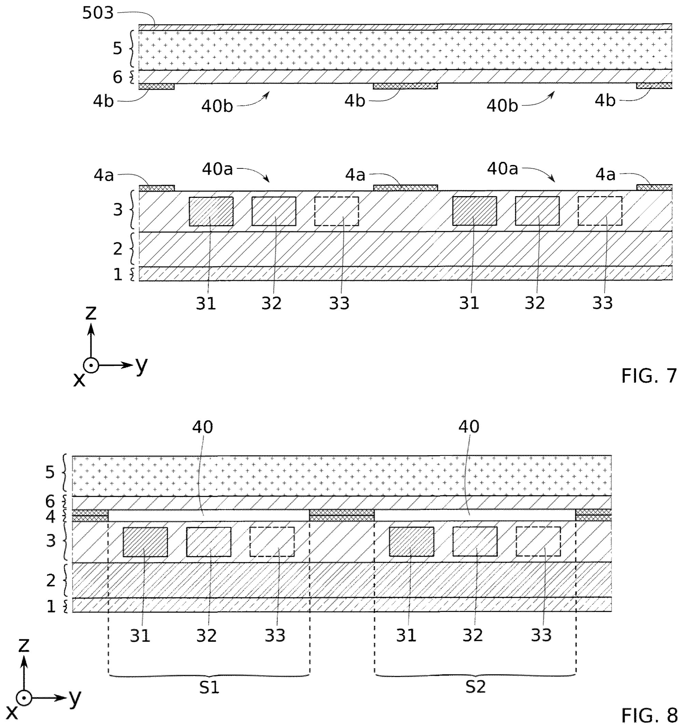

Comme illustré à la figure 6, après dépôt en continu de la deuxième partie 4b de couche de liaison, des deuxièmes ouvertures 40b sont formées de manières connues, typiquement par lithographie et gravure, dans cette deuxième partie 4b de couche de liaison. La couche 6 est exposée au travers des deuxièmes ouvertures 40b. Les deuxièmes ouvertures 40b sont configurées pour correspondre au moins en partie et de préférence totalement aux premières ouvertures 40a. Ainsi, les deuxièmes ouvertures 40b présentent les mêmes formes et dimensions que les premières ouvertures 40a, selon une symétrie par rapport au plan xy. Cela permet d'optimiser la formation ultérieure des cavités 40 détaillées par la suite sur la figure 8.

Comme illustré à la figure 7, après formation des première et deuxième parties 4a, 4b de couche de liaison sur l'empilement de couches électronique, d'émission 2, de conversion 3 d'une part et sur la couche de support transparente 5 d'autre part, celles-ci sont mises en regard l'une de l'autre et alignées l'une vis-à-vis de l'autre en vue d'être assemblées.

La figure 8 illustre cet assemblage. L'assemblage métal/métal ou silicium amorphe/silicium amorphe ou germanium amorphe/ germanium amorphe entre les parties 4a, 4b se fait typiquement à température ambiante, par exemple selon un procédé d'assemblage par activation de surface. Selon ce procédé, les surfaces des parties 4a, 4b peuvent être activées par un bombardement d'atomes d'argon sous vide avant collage. Un tel procédé est par exemple décrit dans le document « Surface activated bonding of silicon wafers at room temperature, H. Takagi et al., Appl. Phys. Lett. 68, 2222-2224 (1996) ». Ce procédé d'assemblage peut être mis en œuvre au sein d'un équipement EVG^{®} ComBond^{®}. Des liaisons covalentes sont typiquement formées entre les parties 4a, 4b pour obtenir la couche de liaison 4 et les cavités 40. Les cavités 40 sont à l'aplomb des structures optiquement actives correspondant aux zones d'émission S1, S2 des couches d'émission 2 et de conversion 3, entre la couche de support transparente et la couche sensible. Ces cavités 40 au-dessus des structures optiquement actives permettent un passage optique au travers de la couche de liaison, c'est-à-dire sont transparentes aux longueurs d'onde émises par les zones d'émission S1, S2. Après assemblage, la couche opaque sur la couche de support 5, ou la face opacifiée de la couche de support 5, est retirée, typiquement par rognage mécanique et/ou polissage mécano-chimique, afin d'obtenir une couche de support 5 transparente pour le dispositif. La couche opaque peut également être retirée par gravure plasma ou gravure humide.

Ainsi, à l'issue de l'assemblage, le dispositif optoélectronique comprend typiquement, en empilement selon z :
- une couche d'électronique comprise dans un substrat 1 comprenant des transistors,
- une couche émissive 2 comprenant des LEDs à base de GaN,
- une couche de conversion 3 comprenant des modules de conversion de couleur 31, 32, 33,
- une couche de liaison 4 comprenant des cavités 40 au-dessus des zones d'émission S1, S2 des couches d'émission 2 et de conversion 3,
- une couche de support transparente 5.

Avantageusement, lors de la fabrication du dispositif, les modules de conversion de couleur 31, 32, 33 sensibles à la température n'ont pas été exposés à des températures supérieures à 150°C. Les modules de conversion de couleur 31, 32, 33 ont été préservés. Avantageusement, les cavités 40 sont hermétiques et sous vide. Cela empêche que la couche de conversion 3 soit exposée à une atmosphère humide ou oxydante. La durée de vie de la couche de conversion 3 est augmentée.

Avantageusement, les pixels comprenant par exemple chacun les sous-pixels RGB, sont séparés par découpe pour être déplacés puis fixés à un autre substrat. La découpe peut par exemple se faire par sciage mécanique ou par découpe au laser, à travers l'empilement spécifiquement au niveau de l'assemblage des parties 4a, 4b de la couche de liaison 4. La découpe sera plus facile dans la présente invention qu'avec une couche de liaison à base de colle organique.

L'invention n'est pas limitée aux modes de réalisations précédemment décrits. La couche optiquement active 2 peut comprendre des composants récepteurs de lumière, tels que des détecteurs. La couche sensible 3 peut comprendre n'importe quelle structure sensible à la température, en particulier des structures qui se dégradent thermiquement au-delà de 200°C, voir au-delà de 150°C.

L'étendue de la présente invention est définie par les revendications qui suivent.

## Revendications

1. Dispositif optoélectronique comprenant en empilement selon une direction z :
• au moins une couche émettrice (2) comprenant des structures optiquement actives, configurées pour émettre ou recevoir un rayonnement selon une longueur d'onde λ,
• une couche de liaison (4),
• une couche de support (5) transparente,
le dispositif optoélectronique comprenant en outre, dans l'empilement selon la direction z, une couche (3, 3') dite sensible comprenant au moins une structure (31, 32, 33, 34) dite sensible présentant une résistance en température inférieure à une température Tmax,
le dispositif étant **caractérisé en ce que** la couche de liaison (4) est à base d'un matériau de collage inorganique basse température et **en ce que** la couche de liaison (4) comprend des cavités (40) à l'aplomb des structures optiquement actives, entre la couche de support (5) transparente et la couche émettrice comprenant lesdites structure optiquement actives.

2. Dispositif selon la revendication précédente dans lequel la température Tmax est inférieure à 180°C, de préférence inférieure à 150°C.

3. Dispositif selon l'une quelconque des revendications précédentes dans lequel le matériau de collage inorganique basse température est opaque.

4. Dispositif selon l'une quelconque des revendications précédentes dans lequel le matériau de collage inorganique basse température est à base de métal ou de silicium amorphe ou de germanium amorphe.

5. Dispositif selon l'une quelconque des revendications précédentes dans lequel les cavités (40) présentent une pression inférieure à la pression atmosphérique, de préférence au moins une décade inférieure à la pression atmosphérique.

6. Dispositif selon l'une quelconque des revendications précédentes dans lequel les cavités (40) sont transparentes au rayonnement émis ou reçu par les structures optiquement actives.

7. Dispositif selon l'une quelconque des revendications précédentes dans lequel la couche de support (5) transparente est à base de verre.

8. Dispositif selon l'une quelconque des revendications précédentes dans lequel la couche de liaison (4) est formée par un assemblage de première et deuxième parties (4a, 4b) du matériau de collage inorganique, déposées respectivement sur la couche sensible (3) et sur une face de la couche de support (5) transparente.

9. Dispositif selon l'une quelconque des revendications précédentes dans lequel ladite couche émettrice (2) comprenant les structures optiquement actives est à base de GaN ou de GaAs.

10. Dispositif selon l'une quelconque des revendications précédentes dans lequel les structures optiquement actives sont des diodes électroluminescentes et dans lequel la couche (3) dite sensible est agencée entre la couche émettrice (2) et la couche de liaison (4), ladite au moins une structure (31, 32, 33) sensible est un module convertisseur de couleur.

11. Dispositif selon l'une quelconque des revendications 1 à 9 dans lequel les structures optiquement actives sont des diodes électroluminescentes et dans lequel la couche (3') dite sensible est portée par un substrat (1) agencé sous la couche émettrice (2) comprenant les structures optiquement actives, du côté opposé à la couche de liaison (4), ladite au moins une structure sensible étant un transistor (34), de préférence un transistor en couche mince.

12. Dispositif selon l'une quelconque des revendications 1 à 9, dans lequel les structures optiquement actives sont des diodes électroluminescentes, le dispositif comprenant une première couche (3) dite sensible agencée entre la couche émettrice (2) et la couche de liaison (4), et une deuxième couche (3') dite sensible agencée entre un substrat (1) et la couche émettrice (2) comprenant les structures optiquement actives, du côté opposé à la couche de liaison (4), la première couche (3) sensible comprenant au moins une première structure sensible telle qu'un module convertisseur de couleur, la deuxième couche sensible (3') comprenant au moins une deuxième structure sensible telle que un transistor, de préférence un transistor en couche mince.

13. Procédé de fabrication d'un dispositif optoélectronique selon l'une quelconque des revendications 1 à 12, ledit procédé comprenant au moins les étapes suivantes :
• fournir un empilement comprenant au moins une couche émettrice (2) comprenant des structures optiquement actives, configurées pour émettre ou recevoir un rayonnement selon une longueur d'onde λ, et au moins une couche (3, 3') dite sensible comprenant des structures (31, 32, 33, 34) dites sensibles présentant une résistance en température inférieure à une température Tmax,
• former, sur l'empilement, une première partie (4a) de couche de liaison à base d'un matériau de collage inorganique basse température, ladite première partie (4a) comportant des premières ouvertures (40a) à l'aplomb des structures optiquement actives,
• fournir une couche de support (5) transparente,
• former, sur une première face (501) de la couche de support (5) transparente, une deuxième partie (4b) de couche de liaison à base du matériau de collage inorganique basse température, ladite deuxième partie (4b) comportant des deuxièmes ouvertures (40b) configurées pour être mises en correspondance avec lesdites premières ouvertures (40a),
• mettre en regard la deuxième partie (4b) de couche de liaison avec la première partie (4a) de couche de liaison,
• assembler l'empilement comprenant la couche sensible (3, 3') avec la couche de support (5) transparente par collage basse température entre les première et deuxième parties (4a, 4b) de couche de liaison, les premières et deuxièmes ouvertures (40a, 40b) formant alors des cavités (40) à l'aplomb des structures optiquement actives.

14. Procédé selon la revendication précédente dans lequel la première partie (4a) de couche de liaison est d'abord formée en continu sur la couche sensible (3) de l'empilement, puis les premières ouvertures (40a) sont formées dans la première partie (4a) de couche de liaison.

15. Procédé selon l'une des revendications 13 ou 14, dans lequel la deuxième partie (4b) de couche de liaison est d'abord formée en continu sur la première face (501) de la couche de support (5) transparente, puis les deuxièmes ouvertures (40b) sont formées dans la deuxième partie (4b) de couche de liaison.

16. Procédé selon l'une quelconque des revendications 13 à 15 comprenant en outre une opacification d'une deuxième face (502) de la couche de support (5) transparente avant mise en regard des première et deuxième parties (4a, 4b) de couche de liaison, et un retrait de la deuxième face opacifiée (503) après assemblage de l'empilement comprenant la couche sensible (3, 3') avec la couche de support (5) transparente.

17. Procédé selon l'une quelconque des revendications 13 à 16 dans lequel l'assemblage par collage basse température est effectué sous une pression Pc inférieure à la pression atmosphérique Patm, de préférence telle que Pc ≤ 10⁻³.Patm, et de préférence telle que Pc ≤ 10⁻⁸.Patm.

18. Procédé selon l'une quelconque des revendications 13 à 17 dans lequel le matériau de collage inorganique basse température est choisi à base de métal ou de silicium amorphe ou de germanium amorphe.

## Patentansprüche

1. Optoelektronische Vorrichtung, die gestapelt in einer z-Richtung Folgendes umfasst:
• mindestens eine Emittierschicht (2), die optisch aktive Strukturen umfasst, die so eingerichtet sind, dass sie eine Strahlung mit einer Wellenlänge λ emittieren oder empfangen,
• eine Verbindungsschicht (4),
• eine transparente Trägerschicht (5),
wobei die optoelektronische Vorrichtung ferner in der Stapelung in z-Richtung eine empfindliche Schicht (3, 3') umfasst, die mindestens eine empfindliche Struktur (31, 32, 33, 34) mit einem Temperaturwiderstand unterhalb einer Temperatur Tmax umfasst,
wobei die Vorrichtung **dadurch gekennzeichnet ist, dass** die Verbindungsschicht (4) auf einem anorganischen Niedertemperatur-Klebematerial basiert und dass die Verbindungsschicht (4) Hohlräume (40) senkrecht zu den optisch aktiven Strukturen zwischen der transparenten Trägerschicht (5) und der Emitterschicht, die die optisch aktiven Strukturen umfasst, umfasst.

2. Vorrichtung nach dem vorhergehenden Anspruch, wobei die Temperatur Tmax unter 180 °C, vorzugsweise unter 150 °C, liegt.

3. Vorrichtung nach einem der vorhergehenden Ansprüche, wobei das anorganische Niedertemperatur-Klebematerial opak ist.

4. Vorrichtung nach einem der vorhergehenden Ansprüche, wobei das anorganische Niedertemperatur-Klebematerial auf Metall oder amorphem Silizium oder amorphem Germanium basiert.

5. Vorrichtung nach einem der vorhergehenden Ansprüche, wobei die Hohlräume (40) einen Druck aufweisen, der niedriger ist als der Atmosphärendruck, vorzugsweise mindestens eine Dekade niedriger als der Atmosphärendruck.

6. Vorrichtung nach einem der vorhergehenden Ansprüche, wobei die Hohlräume (40) für die von den optisch aktiven Strukturen emittierte oder empfangene Strahlung transparent sind.

7. Vorrichtung nach einem der vorhergehenden Ansprüche, wobei die transparente Trägerschicht (5) auf Blas basiert.

8. Vorrichtung nach einem der vorhergehenden Ansprüche, wobei die Verbindungsschicht (4) durch eine Zusammenfügung eines ersten und eines zweiten Teils (4a, 4b) des anorganischen Klebematerials gebildet wird, die jeweils auf die empfindliche Schicht (3) und auf eine Seite der transparenten Trägerschicht (5) aufgebracht sind.

9. Vorrichtung nach einem der vorhergehenden Ansprüche, wobei die Emittierschicht (2), die die optisch aktiven Strukturen umfasst, auf GaN- oder GaAs-Basis ist.

10. Vorrichtung nach einem der vorhergehenden Ansprüche, wobei die optisch aktiven Strukturen Leuchtdioden sind und wobei die empfindliche Schicht (3) zwischen der Emittierschicht (2) und der Verbindungsschicht (4) angeordnet ist, wobei die mindestens eine empfindliche Struktur (31, 32, 33) ein Farbwandlermodul ist.

11. Vorrichtung nach einem der Ansprüche 1 bis 9, wobei die optisch aktiven Strukturen Leuchtdioden sind und wobei die empfindliche Schicht (3') von einem Substrat (1) getragen wird, das unter der Emittierschicht (2) angeordnet ist, die die optisch aktiven Strukturen auf der der Verbindungsschicht (4) gegenüberliegenden Seite umfasst, wobei die mindestens eine empfindliche Struktur ein Transistor (34), vorzugsweise ein Dünnschichttransistor, ist.

12. Vorrichtung nach einem der Ansprüche 1 bis 9, wobei die optisch aktiven Strukturen Leuchtdioden sind, wobei die Vorrichtung eine erste so genannte empfindliche Schicht (3), die zwischen der Emittierschicht (2) und der Verbindungsschicht (4) angeordnet ist, und eine zweite empfindliche Schicht (3') umfasst, die zwischen einem Substrat (1) und der Emittierschicht (2) angeordnet ist, die die optisch aktiven Strukturen auf der der Verbindungsschicht (4) gegenüberliegenden Seite umfasst, wobei die erste empfindliche Schicht (3) mindestens eine erste empfindliche Struktur wie ein Farbwandlermodul umfasst, wobei die zweite empfindliche Schicht (3') mindestens eine zweite empfindliche Struktur wie einen Transistor, vorzugsweise einen Dünnschichttransistor, umfasst.

13. Verfahren zur Herstellung einer optoelektronischen Vorrichtung nach einem der Ansprüche 1 bis 12, wobei das Verfahren mindestens die folgenden Schritte umfasst:
• Bereitstellen eines Stapels, der mindestens eine Emittierschicht (2), die optisch aktive Strukturen umfasst, die so eingerichtet sind, dass sie eine Strahlung mit einer Wellenlänge λ emittieren oder empfangen, und mindestens eine empfindliche Schicht (3, 3') umfasst, die empfindliche Strukturen (31, 32, 33, 34) mit einem Temperaturwiderstand unterhalb einer Temperatur Tmax umfasst,
• Bilden eines ersten Teils (4a) einer Verbindungsschicht auf Basis eines anorganischen Niedertemperatur-Klebematerials auf dem Stapel, wobei der erste Teil (4a) erste Öffnungen (40a) enthält, die senkrecht zu den optisch aktiven Strukturen verlaufen,
• Bereitstellen einer transparenten Trägerschicht (5),
• Bilden eines zweiten Teils (4b) der Verbindungsschicht auf Basis des anorganischen Niedertemperatur-Klebematerials auf einer ersten Seite (501) der transparenten Trägerschicht (5), wobei der zweite Teil (4b) zweite Öffnungen (40b) enthält, die so eingerichtet sind, dass sie mit den ersten Öffnungen (40a) ausgerichtet werden können,
• Gegenüberstellen des zweiten Teils (4b) der Verbindungsschicht dem ersten Teil (4a) der Verbindungsschicht,
• Zusammenfügen des Stapels, der die empfindliche Schicht (3, 3') mit der transparenten Trägerschicht (5) umfasst, durch Niedertemperatur-Kleben zwischen dem ersten und dem zweiten Teil (4a, 4b) der Verbindungsschicht, wobei die ersten und zweiten Öffnungen (40a, 40b) dann Hohlräume (40) bilden, die senkrecht zu den optisch aktiven Strukturen verlaufen.

14. Verfahren nach dem vorhergehenden Anspruch, wobei der erste Teil (4a) der Verbindungsschicht zunächst durchgehend auf der empfindlichen Schicht (3) des Stapels gebildet wird und dann die ersten Öffnungen (40a) in dem ersten Teil (4a) der Verbindungsschicht gebildet werden.

15. Verfahren nach einem der Ansprüche 13 oder 14, wobei der zweite Teil (4b) der Verbindungsschicht zunächst durchgehend auf der ersten Seite (501) der transparenten Trägerschicht (5) gebildet wird und dann die zweiten Öffnungen (40b) in dem zweiten Teil (4b) der Verbindungsschicht gebildet werden.

16. Verfahren nach einem der Ansprüche 13 bis 15, ferner umfassend das Trüben einer zweiten Seite (502) der transparenten Trägerschicht (5) vor dem Gegenüberstellen des ersten und des zweiten Teils (4a, 4b) der Verbindungsschicht und das Entfernen der zweiten getrübten Seite (503) nach dem Zusammenfügen des Stapels, der die empfindliche Schicht (3, 3') mit der transparenten Trägerschicht (5) umfasst.

17. Verfahren nach einem der Ansprüche 13 bis 16, wobei die Zusammenfügung durch Niedertemperatur-Kleben unter einem Druck Pc unterhalb des Atmosphärendrucks Patm durchgeführt wird, vorzugsweise so dass Pc ≤ 10 ⁻³ .Patm, und vorzugsweise so, dass Pc ≤ 10 ⁻⁸ .Patm.

18. Verfahren nach einem der Ansprüche 13 bis 17, wobei das anorganische Niedertemperatur-Klebematerial auf Basis von Metall oder amorphem Silizium oder amorphem Germanium ausgewählt ist.

## Claims

1. An optoelectronic device comprising as a stack along a z-direction:
• at least one emitting layer (2) comprising optically active structures, configured to emit or receive radiation at a wavelength λ,
• a bonding layer (4),
• a transparent support layer (5),
the optoelectronic device further comprising, in the stack along the z-direction, a so-called sensitive layer (3, 3') comprising at least one so-called sensitive structure (31, 32, 33, 34) having a resistance to a temperature lower than a temperature Tmax,
the device being **characterised in that** the bonding layer (4) is based on a low-temperature inorganic adhesive material and **in that** the bonding layer (4) comprises cavities (40) in vertical alignment with the optically active structures, between the transparent support layer (5) and the emitting layer comprising said optically active structures.

2. The device according to the preceding claim, wherein the temperature Tmax is less than 180°C, preferably less than 150°C.

3. The device according to any one of the preceding claims, wherein the low temperature inorganic adhesive material is opaque.

4. The device according to any one of the preceding claims, wherein the low temperature inorganic adhesive material is based on metal or amorphous silicon or amorphous germanium.

5. The device according to any one of the preceding claims, wherein the cavities (40) have a pressure lower than atmospheric pressure, preferably at least one decade lower than atmospheric pressure.

6. The device according to any one of the preceding claims, wherein the cavities (40) are transparent to the radiation emitted or received by the optically active structures.

7. The device according to any one of the preceding claims, wherein the transparent support layer (5) is glass-based.

8. The device according to any one of the preceding claims, wherein the bonding layer (4) is formed by assembling first and second parts (4a, 4b) of the inorganic adhesive material, respectively deposited onto the sensitive layer (3) and onto a face of the transparent support layer (5).

9. The device according to any one of the preceding claims, wherein said emitting layer (2) comprising the optically active structures is based on GaN or GaAs.

10. The device according to any one of the preceding claims, wherein the optically active structures are light-emitting diodes and wherein the so-called sensitive layer (3) is arranged between the emitting layer (2) and the bonding layer (4), said at least one sensitive structure (31, 32, 33) is a colour converter module.

11. The device according to any one of claims 1 to 9, wherein the optically active structures are light-emitting diodes and wherein the so-called sensitive layer (3') is carried by a substrate (1) arranged under the emitting layer (2) comprising the optically active structures, on the side opposite to the bonding layer (4), said at least one sensitive structure being a transistor (34), preferably a thin-film transistor.

12. The device according to any one of claims 1 to 9, wherein the optically active structures are light-emitting diodes, the device comprising a first so-called sensitive layer (3) arranged between the emitting layer (2) and the bonding layer (4), and a second so-called sensitive layer (3') arranged between a substrate (1) and the emitting layer (2) comprising the optically active structures, on the side opposite the bonding layer (4), the first sensitive layer (3) comprising at least one first sensitive structure such as a colour converter module, the second sensitive layer (3') comprising at least one second sensitive structure such as a transistor, preferably a thin-film transistor.

13. A method for manufacturing an optoelectronic device according to any one of claims 1 to 12, said method comprising at least the following steps of:
• providing a stack comprising at least one emitting layer (2) comprising optically active structures, configured to emit or receive radiation at a wavelength λ, and at least one so-called sensitive layer (3, 3') comprising so-called sensitive structures (31, 32, 33, 34) having a resistance to a temperature lower than a temperature Tmax,
• forming, on the stack, a first part (4a) of bonding layer based on a low-temperature inorganic adhesive material, said first part (4a) including first openings (40a) in vertical alignment with the optically active structures,
• providing a transparent support layer (5),
• forming, on a first face (501) of the transparent support layer (5), a second part (4b) of bonding layer based on the low-temperature inorganic adhesive material, said second part (4b) including second openings (40b) configured to be matched with said first openings (40a),
• facing the second part (4b) of bonding layer with the first part (4a) of bonding layer,
• assembling the stack comprising the sensitive layer (3, 3') with the transparent support layer (5) by low-temperature adhering between the first and second parts (4a, 4b) of bonding layer, the first and second openings (40a, 40b) thereby forming cavities (40) in vertical alignment with the optically active structures.

14. The method according to the preceding claim, wherein the first part (4a) of bonding layer is first continuously formed on the sensitive layer (3) of the stack, and then the first openings (40a) are formed in the first part (4a) of bonding layer.

15. The method according to one of claims 13 or 14, wherein the second part (4b) of bonding layer is first continuously formed on the first face (501) of the transparent support layer (5), and then the second openings (40b) are formed in the second part (4b) of bonding layer.

16. The method according to any one of claims 13 to 15, further comprising opacifying a second face (502) of the transparent support layer (5) before facing the first and second parts (4a, 4b) of the bonding layer with each other, and removing the second opacified face (503) after assembling the stack comprising the sensitive layer (3, 3') with the transparent support layer (5).

17. The method according to any one of claims 13 to 16, wherein assembling by low-temperature adhering is carried out under a pressure Pc lower than the atmospheric pressure Patm, preferably such as Pc ≤ 10⁻³.Patm, and preferably such as Pc ≤ 10⁻⁸.Patm.

18. The method according to any one of claims 13 to 17, wherein the low-temperature inorganic adhesive material is chosen based on metal or amorphous silicon or amorphous germanium.
